(19) Europäisches Patentamt

European Patent Office

Office européen des brevets

(11) Veröffentlichungsnummer: **0 408 799 B1**

(12) **EUROPÄISCHE PATENTSCHRIFT**

(45) Veröffentlichungstag der Patentschrift: **14.04.93**

(21) Anmeldenummer: **89113404.1**

(22) Anmeldetag: **21.07.89**

(51) Int. Cl.⁵: **G01D 5/245**, H03M 1/00

(54) **Verfahren zum Interpolieren von Positionsmesssignalen.**

(43) Veröffentlichungstag der Anmeldung:
**23.01.91 Patentblatt 91/04**

(45) Bekanntmachung des Hinweises auf die
Patenterteilung:
**14.04.93 Patentblatt 93/15**

(84) Benannte Vertragsstaaten:
**DE FR GB IT**

(56) Entgegenhaltungen:
**EP-A- 0 172 803**
**WO-A-89/01607**
**GB-A- 2 179 515**

(73) Patentinhaber: **Dr. Johannes Heidenhain
GmbH
Dr.-Johannes-Heidenhain-Strasse 5 Postfach
1260
W-8225 Traunreut(DE)**

(72) Erfinder: **Kranitzky, Walter, Dr.
Innstrasse 15
W-8220 Traunstein(DE)**

**Beschreibung**

Die Erfindung bezieht sich auf ein Verfahren gemäß dem Oberbegriff des Anspruches 1.

Inkrementale Meßsysteme, bei denen die Erfindung Anwendung findet, liefern bekanntlich Impulse, deren Anzahl ein Maß für die lineare Verschiebung oder den Drehwinkel darstellt. Diese Impulse werden in einem elektronischen Vor-/Rückwärtszähler als Wegelemente aufsummiert und der Meßwert numerisch angezeigt.

Die Auflösung von inkrementalen Positionsmeßeinrichtungen ist ohne weitere elektronische Unterteilung zunächst nur 1/4 der Teilungsperiode, da von zwei um 90° zueinander versetzten Fotodetektoren der Abtasteinheit zwei entsprechend zueinander phasenverschobene Signale U1 und U2 erzeugt werden, die vier Nulldurchgänge zum Erzeugen von Zählimpulsen aufweisen. Besitzen die beiden Signale eine genügend gute Sinusform, lassen sie sich zwischen den Nulldurchgängen auf verschiedene Weise elektrisch interpolieren.

Für das nachstehende Beispiel sei die CH-PS 4 07 569 genannt.

Eine Möglichkeit zur elektronischen Meßwertinterpolation ist die Erzeugung von zusätzlichen Hilfsphasen in einem Widerstandsnetzwerk. Die mathematische Grundlage dafür bietet das Additionstheorem. Wählt man die Amplituden der beiden Signale

$U1 = A1\sin(2\pi X/T)$ und $U2 = A2\cos(2\pi X/T)$ wobei $T$ = Signalperiode so, daß $A1 = \cos\phi$ und $A2 = \sin\phi$ ergibt sich durch Addition der beiden Signale ein neues Signal

$$U = \sin(\phi + 2\pi X/T)$$

das zu U1 um $\phi$ phasenverschoben ist. X ist der Weg oder der Winkel und $\phi$ eine Hilfsgröße, die entsprechend dem geforderten Interpolationsgrad gewählt wird.

In modernen Auswerteelektroniken werden auf diese Weise bis zu 25fach-phasenverschobene Signale erzeugt, und somit Auflösungen des Meßsystems bis zu 1/100 der Maßstabteilungsperiode erreicht.

Für derartig hohe Unterteilungen ist allerdings der Schaltungsaufwand bereits hoch, da für jedes phasenverschobene Signal ein Schaltbaustein vorgesehen werden muß. So muß bisher die Anzahl der Komparatoren immer das Doppelte des Unterteilungsfaktors betragen.

Aus der EP-A- 0 172 803 ist ein Verfahren zur Interpolation bekannt, bei der Meßwert-Korrekturwerte in Korrekturspeichern abgelegt sind, wobei zur Korrektur nur die entsprechenden Korrekturadressen angesprochen werden müssen.

Eine wesentliche Verbesserung bzw. Vereinfachung wird erzielt, wenn bei derartigen Meßsystemen die Interpolationswerte in Form einer Arcus/Tangens-Tabelle in einem Speicher abgelegt sind. Die Speicheradressen werden durch einen Code, der durch die zwei zueinander phasenverschobenen Abtastsignale gebildet wird, angesteuert. Dieses Prinzip ist in der GB-A- 2179515 offenbart. Dieser Druckschrift ist auch zu entnehmen, daß der Speicherinhalt auf den Raum eines Quadranten eines Zyklus reduziert werden kann. An den Quadrantengrenzen findet ein nicht näher erläuterter Adressenwechsel statt. Für eine weitere Reduzierung des Adressenraumes liefert diese Druckschrift keine Anregung.

Der vorliegenden Erfindung liegt die Aufgabe zugrunde, ein Verfahren der eingangs genannten Art anzugeben, mit dem der Adressenraum des Speichers noch weiter reduziert werden kann.

Diese Aufgabe wird durch ein Verfahren mit den Merkmalen des Anspruches 1 gelöst.

Die Vorteile des erfindungsgemäßen Verfahrens liegen darin, daß durch die Möglichkeit, den Adressenraum des Speichers weiter zu reduzieren, der Speicher kostengünstig in einem VLSI-Schaltkreis integriert werden kann.

Anhand der Zeichnungen soll das Verfahren noch näher erläutert werden.

Es zeigt

Figur 1    eine Prinzipskizze eines inkrementalen Meßsystems;

Figur 2    einen Speicher mit 256 Speicherplätzen und

Figur 3    einen Speicher gemäß Figur 2, bei dem der Speicher noch Informationen für die Signalüberwachung enthält.

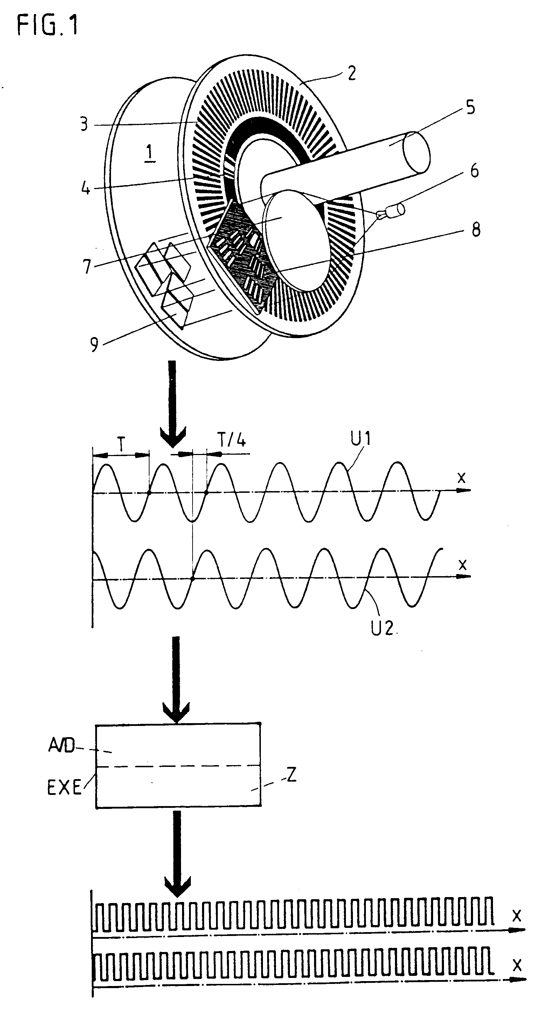

Ein in Figur 1 skizziertes Meßsystem 1 wird durch einen inkrementalen Drehgeber gebildet. Als Maßverkörperung dient hier eine Teilscheibe 2 mit einem Radialgitter 3. Auf einer weiteren konzentrischen Spur befindet sich eine Referenzmarke 4, die hier aber nicht weiter abgehandelt werden soll. Die Teilscheibe 2 ist mit einer Welle 5 verbunden, deren Position gemessen werden soll. Dazu wird das Radialgitter 3 von einer nicht näher bezeichneten Abtasteinheit abgetastet. Die wesentlichen Bestandteile der Abtasteinheit sind eine Lichtquelle 6, ein Kondensor 7, eine Abtastplatte 8 und Fotodetektoren 9.

Bei einer Bewegung der Teilscheibe 2 relativ zur Abtasteinheit kommen die Striche und Lücken des Radialgitters 3 abwechselnd mit denen der Abtastgitter der Abtastplatte 8 zur Deckung. Die Fotodetektoren 9 setzen den sich periodisch ändernden Lichtstrom in elektrische Signale um. Als Ausgangssignale stehen zwei sinusförmige Signale U1 und U2 zur Verfügung. Sie sind um 90° elektrisch zueinander phasenverschoben, was durch zwei Fotodetektoren 9 bewirkt wird, die um 1/4 der Teilungsperiode T zueinander versetzt sind.

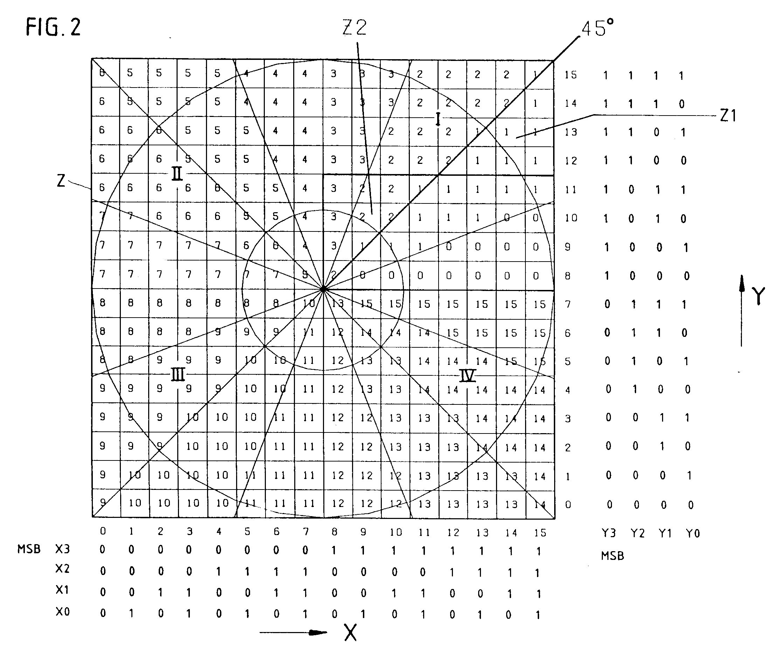

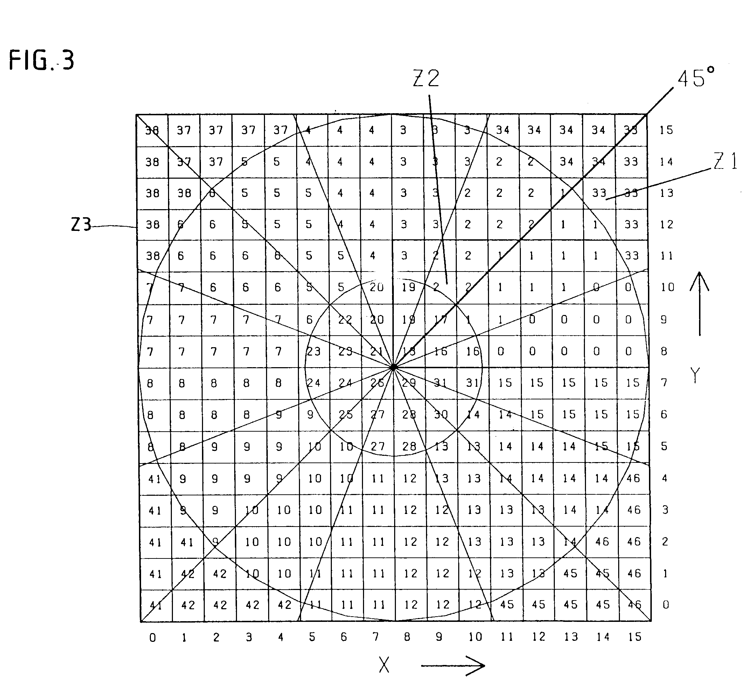

In einer Auswerteeinrichtung EXE erfolgt die Digitalisierung und die Interpolation. Die Interpolationswerte werden vorab ermittelt und sind in einem Festwertspeicher Z bzw. Z3 abgespeichert, der in den Figuren 2 und 3 schematisch dargestellt ist. Am Ausgang der Auswerteeinrichtung EXE stehen die digitalisierten und interpolierten Signale in Form von zählbaren Rechtekimpulsen an.

Figur 2 zeigt schematisch einen Speicher Z. Das erfindungsgemäße Prinzip ist auf beliebige Anzahlen von Daten- und Adressenbits anwendbar. Anhand dieses konkreten Beispiels wird es mit einem Adreßraum von 2 x 4 Bit erklärt. Der Speicher Z hat also eine Anzahl von Speicherplätzen, die in der Koordinatenrichtungen X, Y den dezimalen Wertebereich von 0 bis 15 aufweisen. Diese 256 Speicherplätze enthalten 256 Datenworte, die für eine volle Interpolation einer Teilungs- oder Signaleperiode T über 360° notwendig sind. Jedes Datenwort ist über die Adresse seines Speicherplatzes anwählbar. Dabei bewährt es sich, die Adresse mittels der zugehörigen Koordinaten in Form eines binären Codes mit den vorerwähnten 4 Bit Wortbreite zu kennzeichnen.

Der Speicher Z ist in 16 Segmente unterteilt. Diese werden durch die vier Bit des Codes gekennzeichnet und geben den Winkel innerhalb einer Signalperiode an, die ja der Teilungsperiode t entspricht. Die Datenworte in den Speicherplätzen sind Codewerte, die von der Arcustangensbeziehung der Signale U1 und U2 sowie dem Unterteilungsfaktor abhängig sind. Durch eine Symmetriebetrachtung wird deutlich, daß sich die Datenworte, abgesehen von additiven Konstanten zyklisch wiederholen. Somit ist es möglich, den Adressenraum des Speichers Z weiter zu reduzieren, hier zum Beispiel auf ein Achtel.

Dazu werden zunächst die Quadranten II, III und IV durch Spiegelung der Adressen an der X- und Y-Achse auf den ersten Quadranten "abgebildet".

Die höchstwertigen Bits (most significant bits = MSB) legen den Quadranten fest; folgende Adreß- und Datenzuordnung bewirkt die Spiegelung:

| X3 | Y3 | Quadrant | X2': X0' | Y2':Y0' | d |
|----|----|----------|----------|---------|---|
| 1 | 1 | I | X2 : X0 | Y2:Y0 | d' |
| 0 | 1 | II | $\overline{X2} : \overline{X0}$ | Y2:Y0 | 7−d' |
| 0 | 0 | III | $\overline{X2} : \overline{X0}$ | $\overline{Y2}:\overline{Y0}$ | 8+d' |
| 1 | 0 | IV | X2 : X0 | $\overline{Y2}:\overline{Y0}$ | 15−d' |

(A)

Darin bedeuten:

X3 und Y3     die MSB der Adreßkoordinaten,

X2 und Y2 ⎫

X1 und Y1 ⎬    die niederwertigeren Bits in fallender Reihenfolge bis zum

X0 und Y0 ⎭    LSB (least significant bit)

X3 : X0     ist dabei die Original-X-Adresse,
Y3 : Y0     ist dabei die Original-Y-Adresse und
d     ist der Original-Speicherinhalt.
$X2' : X0'$     ist die "gespiegelte" X-Adresse
$Y2' : Y0'$     ist die "gespiegelte" Y-Adresse und
$d'$     ist der "gespiegelte" Speicherinhalt.

Der Original-Speicherinhalt d ergibt sich aus der Transformationstabelle (A).

Anhand der folgenden Beispiele soll eine Quadranten-Transformation durchgeführt werden.

Durch die beiden periodischen analogen Abtastsignale wird an einer beliebigen Position der Momentanwert gebildet. Dessen Digitalisierung führt zu einem bestimmten binären Code, der die Adresse im Speicher Z bestimmt.

Für das gegenwärtige Beispiel soll die Adresse $X = 4$ und $Y = 7$ lauten, was in binärer Form $X = 0100$ und $Y = 0111$ ist. Aufgeschlüsselt nach der Wertigkeit der Bits ergibt sich $X3 = 0$, $X2 = 1$, $X1 = 0$, $X0 = 0$ und $Y3 = 0$, $Y2 = 1$, $Y1 = 1$, $Y0 = 1$. Die beiden MSB X3 und Y3 bestimmen den Quadranten, in dem diese Adresse aufzufinden ist. Da beide Bits 0 sind, liegt gemäß der Transformationstabelle (A) die Adresse im Quadranten III. Da jedoch gemäß der Erfindung der Speicherraum erheblich reduziert sein soll, muß die Adresse vom Quadranten III auf den Quadranten I transformiert werden. Die dazu erforderlichen Regeln entnimmt man der Transformationstabelle (A). Das MSB ist bereits "verbraucht", also stehen noch drei Bit zur Spiegelung zur Verfügung. Die gespiegelte Adresse hat die Koordinaten $X2' : X0'$ und $Y2' : Y0'$. Für den dritten Quadranten müssen dazu die ursprüngslichen verbleibenden drei Bit invertiert werden, also $\overline{X2 : X0}$ und $\overline{Y2 : Y0}$. So ergibt sich für $X2' : X0'$ der binäre Code 011 und für $Y2' : Y0'$ der binäre Code 000. Die Adresse mit diesem Code lautet im Quadranten I dezimal $X' = 11$ und $Y' = 8$. Unter dieser Adresse befindet sich das Datenwort $d'$ mit dem Wert "0". Gemäß der Transformationstabelle (A) erreichnet sich der wahre Interpolationswert, der als Datenwort d im Quadranten III unter der Adresse $X = 4$ und $Y = 7$ stehen müßte, aus $8 + d'$. Da $d'$ jedoch den Wert 0 hat, lautet der korrekte Interpolationswert 8. Daß dieses Ergebnis korrekt ist, zeigt der Inhalt des Speichers Z, der ja wegen der Erläuterung vollständig dargestellt ist.

Die vorbeschriebenen Vorgänge sollen nachstehend an einem weiteren Beispiel in tabellarischer Form nochmals dargestellt werden:

$$X = 2 \qquad X3 = 0 \qquad\qquad\qquad X2 = 0 \qquad X1 = 1 \qquad X0 = 0$$
$$\phantom{X = 2 \qquad X3 = 0 \qquad} \rightarrow \text{II}$$
$$Y = 13 \qquad Y3 = 1 \qquad\qquad\qquad Y2 = 1 \qquad Y1 = 0 \qquad Y0 = 1$$

$$d = ?$$

$$X2' : X0' \qquad\qquad\qquad \overline{X2} = 1 \qquad \overline{X1} = 0 \qquad \overline{X0} = 1$$
$$\phantom{X2' : X0'} \rightarrow$$
$$Y2' : Y0' \qquad\qquad\qquad Y2 = 1 \qquad Y1 = 0 \qquad Y0 = 1$$

$$X' = 13 \qquad d = 7 - d'$$
$$Y' = 13 \qquad d = 7 - 1$$
$$d' = 1 \qquad d = 6$$

Die Kontrolle im Quadranten II ergibt, daß unter der Adresse $X = 2$ und $Y = 13$ der Speicherwert 6 steht, die Adressentransformation in den ersten Quadranten hat also zur korrekten Errechnung des Interpolationswertes geführt.

Analog zu den vorstehenden Transformationen erfolgt die Abbildung des zweiten Oktanten auf den ersten Oktanten durch Spiegelung an der 45°-Geraden. Die Differenz zwischen $X2' : X0'$ und $Y2' : Y0'$ (also der "quadranten-gespiegelten" Adressen $X'$ und $Y'$) legt den Oktanten fest; folgende Adreß- und Datenzuordnung bewirkt die Oktanten-Spiegelung:

| .S | Oktant | X2" : X0" | Y2" : Y0" | d' |  |
|----|--------|-----------|-----------|-----|-----|
| >0 | 1 | X2' : X0' | Y2' : Y0' | d" | (B) |
| =0 | 45 Grad | | | | |
| <0 | 2 | Y2' : Y0' | X2' : X0' | 3-d" | |

Dabei ist S die Differenz der quadranten-gespiegelten Adressen $X'$ und $Y'$.

$X2''$ : $X0''$ und $Y2''$ : $Y0''$ stellen die binären Adressen des oktanten-gespiegelten Speicherplatzes mit den dezimalen Koordinaten $X''$ und $Y''$ dar. $d''$ ist dementsprechend der ermittelte oktanten-gespiegelten Speicherwert.

Am folgenden Beispiel wird ein Interpolationswert ermittelt, der im Quadranten IV liegt und dessen Adresse schrittweise gemäß der Transformationstabellen (A) und (B) in den ersten Oktanten transformiert wird.

```
X=11      X3=1             X2=0      X1=1      X0=1  ⎫
                  -> IV                              ⎪
Y= 2      Y3=0             Y2=0      Y2=1      Y0=0  ⎪
                                                    ⎪
d= ?                                                ⎪
                                                    ⎪
          X2':X0'          X2=0     X1=1     X0=1   ⎪
                     ->                             ⎬  gemäß
          Y2':Y0'          Y̅2̅=1    Y̅1̅=0    Y̅0̅=1   ⎪    (A)
                                                    ⎪
                                                    ⎪
X'=11     d=15-d'                                   ⎪
                                                    ⎪
Y'=13     d=15-2                                    ⎪
                                                    ⎪
d'=2      d=13                                      ⎭
```

```
X' - Y' = 11 - 13 = -2   --> Oktant 2              ⎫
                                                    ⎪
          X2":X0"   Y2'=1   Y1'=0   Y0'=1          ⎪
                   ->                               ⎪
          Y2":Y0"   X2'=0   X1'=1   X0'=1          ⎬  gemäß
                                                    ⎪    (B)
X"=13     d'=3-d"                                   ⎪
                                                    ⎪
Y"=11     d'=3-1                                    ⎪
                                                    ⎪
d"= 1     d'=2                                      ⎭
```

Vollzieht man dieses Beispiel im vollständig dargestellten Speicher Z nach, so wird die korrekte Ermittlung des Interpolationswertes durch die Adressen- und Datentransformation bestätigt.

Ein sogenannter Quantisierungsfehler kann jedoch dann auftreten, wenn bei der Spiegelung der Oktanten Speicherplätze mit gleicher X- und Y-Adresse auf der 45°-Geraden liegen. Der Datenwert kann in diesen Fällen durch $d''$ oder $3-d''$ bestimmt sein. Dies ist jedoch kein spezifischer Nachteil der Erfindung, sondern der Quantisierungsfehler tritt in der Digitaltechnik in Grenzbereichen immer auf.

Die nunmehr noch benötigte Anzahl von Speicherplätzen entspricht nicht genau einem Achtel der ursprünglich notwendigen Anzahl. Im Beispiel werden nicht 32 sondern 36 Speicherzellen benötigt. Überdies erfolgt die Adressierung nach wie vor durch 2 x 3 Adreßleitungen, wobei bestimmten Kombinationen keine Datenworte zugeordnet sind.

Um eine platzsparende Integration in einem VLSI-Schaltkreis zu ermöglichen, muß der dreieckförmige Adreßbereich (36 Worte) auf einen rechteckförmigen Bereich (32 Worte) abgebildet werden. Hierzu wird folgendes Verfahren vorgeschlagen:

Jede auf der 45°-Geraden liegende Speicherzelle, für welche das höchstwertige Adreßbit gleich 1 ist, wird durch Dekrementieren der X- oder Y-Adresse auf ihren linken bzw. unteren Nachbarn abgebildet. Die Wahl zwischen X- und Y-Dekrement kann statisch oder nach geraden bzw. ungeraden Adressen im Wechsel erfolgen (im Beispiel wurde der zweite Fall angenommen).

| X2"=Y2"=1 | X2''':X0''' | Y2''':Y0''' | d" |
|---|---|---|---|
| X0"=Y0"=beliebig oder: | (X2":X0")-1 | Y2":Y0" | d''' |
| X0"=Y0"=beliebig oder: | X2":X0" | (Y2":Y0")-1 | d''' (C) |
| X0"=Y0"= 0 | (X2":X0")-1 | Y2":Y0" | d''' |
| X0"=Y0"= 1 | X2":X0" | (Y2":Y0")-1 | d''' |

Dabei muß allerdings beachtet werden, daß diejenigen Speicherplätze, die auf ihren linken Nachbarn abgebildet werden, den Adreßbereich des ersten Oktanten verlassen und demgemäß nach der Transformationstabelle (B) wieder in den ersten Oktanten gespiegelt werden müssen.

Auf diese Weise wird die Anzahl der benötigten Speicherplätze im Beispiel von 36 auf 32 verringert.

Ferner muß das in Figur 2 mit Z1 bezeichnete Teildreieck des Speichers Z auf einen Adreßraum abgebildet werde, der ebenfalls dreieckförmig und mit Z2 bezeichnet ist. Dafür wird die Transformationstabelle (D) benötigt.

| Y2''' | X2"":X0"" | Y1"":Y0"" | d''' |
|---|---|---|---|
| 0 | X2''':X0''' | Y1''':Y0''' | d"" |
| 1 | (0:Y1''':Y0''') | X1''':X0''' | d"" |

(D)

Wie schon aus der Transformationstabelle (C) ersichtlich ist, entspricht das neue Datenwort d''' bzw. d"" jeweils dem vorhergehenden, so daß die Werte im Speicher Z gemäß der Figur 2 nicht mehr maßgebend sind, da zum Verständnis der ersten Transformationen ja die ursprünglichen Datenworte angegeben sind, und die additiven Veränderungen nicht in den Speicher Z gemäß Figur 2 eingetragen wurden.

Durch die Transformation - wenn sie nachvollzogen wird wie zu (A) und (B) - läßt sich ohne weiteres die neue Lage des Speicherplatzes bestimmen, jedoch kann nicht der Speicherinhalt aus dem Beispiel abgelesen werden. Dazu müßte die Zeichnung ständig geändert werden, was sich aber erübrigt, da es als hinreichend angesehen wird, wenn die ersten Umwandlungen nachvollzogen werden können. Ferner ändert sich ja bei den letzten Transformationen nur die Lage (Adresse) des Speicherplatzes, nicht jedoch sein Inhalt.

In Figur 3 ist ein Speicher Z3 dargestellt, dessen Speicherinhalt über die Interpolationswerte hinaus noch Informationen über die Signalamplitude enthält.

Durch zusätzliche zwei Bits, die höherwertig sind, als die zur Adressierung benötigten Bits, werden drei Bereiche kodiert, die unterschiedliche Beträge der Signalamplitude kennzeichnen.

6

Zwei konzentrische Kreise in Fugur 3 machen dies deutlich. Bekanntlich entsteht ein Kreis, wenn man die momentanen Werte von Sinus und Cosinus in einem Koordinatensystem einträgt. Der Durchmesser des Kreises ist dabei vom Betrag der Amplituden abhängig. Die Fläche innerhalb des Kreises mit dem kleineren Durchmesser gibt den Bereich an, in dem die Amplituden zu klein sind, um die Abtastsignale auswerten zu können. Der Bereich außerhalb des Kreises mit dem größeren Durchmesser gibt den Übersteuerungsbereich an, d. h., die Signalamplituden sind zu groß. Der zulässige Bereich liegt also auf der Kreisringsfläche zwischen den beiden Kreisen.

Ein Vergleich der Datenworte in den Speicherplätzen der Speicher Z und Z3 zeigt, daß die Datenworte innerhalb des zulässigen Bereiches im Speicher $Z'$ die gleichen Werte haben, wie die Speicherinhalte im Speicher Z (Figur 2). Innerhalb des kleinen Kreises und außerhalb des großen Kreises weichen sie hingegen von den Werten gemäß Figur 2 ab.

Unter den Koordinaten $X = 15$ und $Y = 3$ ist der Speicherinhalt gemäß Figur 2 "14". In dualer Schreibweise ergibt sich 1110. Wird dieser Code um zwei Bit ergänzt, und zwar so, daß bei Überschreitung des zulässigen Amplitudenbereiches das nunmehr höchstwertigste Bit 1 ist und bei Unterschreitung des zulässigen Amplitudenbereiches das nächst niedrigere Bit 1 ist, so ergibt sich folgender Code:

| max | min | Interpolationswert (14) | | | |
|-----|-----|------|------|------|------|
| 1 | 0 | 1 | 1 | 1 | 0 |

Wandelt man diesen Code in eine Dezimalzahl um, so ergibt sich der Wert "46", was dem Speicherinhalt mit der Adresse $X = 15$, $Y = 3$ im Speicher Z3 von Figur 3 entspricht.

Wenn die beiden zusätzlichen Bits "0" sind, befindet man sich also im zulässigen Amplitudenbereich. Auf diese Weise ist eine Signalüberwachung mit Hilfe des Speicherinhaltes möglich.

**Patentansprüche**

1. Verfahren zur Ermittlung eines Winkels oder eines Weges mittels einer Unterteilungsschaltung für analoge periodische Signale, bei dem die Unterteilungsschaltung wenigstens einen Speicher aufweist, auf dessen adressierbaren Speicherplätzen in reduziertem Umfang digitale Interpolationsdaten für eine Signalperiode der vorgenannten Signale abgelegt sind, dadurch gekennzeichnet, daß die Anzahl der Speicherplätze auf ein Achtel reduziert ist und somit einen Oktanten des für eine volle Interpolation von 360° notwendigen Speicherraumes einnimmt, wobei korrekte Interpolationswerte durch mehrere unterschiedliche Adressentransformationen und durch Addition oder Subtraktion von unterschiedlichen Konstanten zu bzw. von den Interpolationsdaten in den adressierten Speicherplätzen gewonnen werden.

2. Speicher für ein Verfahren nach Anspruch 1, dadurch gekennzeichnet, daß ein dreieckförmiger Speicherplatz-Bereich (Z1) des Oktanten in einen rechteckförmigen Speicherplatz-Bereich (Z2) umgewandelt ist.

3. Verfahren nach Anspruch 1, dadurch gekennzeichnet, daß jedes analoge periodische Signal (U1, U2) durch einen Analog-/Digitalwandler (A/D) in ein digitales Wort mit jeweils einer Vielzahl von Bits umgewandelt wird, denen eine entsprechende Adresse des Speichers (Z, Z3) zugeordnet ist.

4. Speicher nach Anspruch 2, dadurch gekennzeichnet, daß der Speicher (Z) in einem VLSI-Schaltkreis integrierbar ist.

5. Verfahren nach Anspruch 1, dadurch gekennzeichnet, daß aus den Interpolationsdaten in bestimmten Speicherplätzen Fehlermeldungen gewonnen werden, wenn die Analogsignale (U1, U2) außerhalb eines vorbestimmten Bereiches liegen.

**Claims**

1. A method of determining an angle or a displacement by means of a sub-dividing circuit for analog periodic signals, in which the sub-dividing circuit has at least one memory in whose addressable memory locations digital interpolation data for one signal period of the aforesaid signals are entered in a reduced range, characterized in that the number of memory locations is reduced to an eighth and these locations thus occupy one octant of the memory space required for a full interpolation of 360°,

7

wherein correct interpolation values are derived by a plurality of different address transformations and by addition or subtraction of different constants to or from the interpolation data in the addressed memory locations.

2. A memory for a method according to claim 1, characterized in that a triangular shaped memory location region (Z1) of the octant is converted into a rectangular memory location region (Z2).

3. A method according to claim 1, characterized in that each periodic analog signal (U1, U2) is converted by an analog-to-digital converter (A/D) into a digital word with a plurality of bits, with which a corresponding address of the memory (Z, Z3) is associated.

4. A memory according to claim 2, characterized in that the memory (Z) can be integrated in a VLSI circuit.

5. A method according to claim 1, characterized in that error messages are obtained from the interpolation data in specified memory locations, when the analog signals (U1, U2) lie outside a predetermined range.

**Revendications**

1. Procédé de détermination d'un angle ou d'une course au moyen d'un circuit diviseur de signaux périodiques analogiques, dans lequel le circuit diviseur comporte au moins une mémoire dans les emplacements adressables de laquelle sont stockées en volume réduit des données numériques d'interpolation pour une période de signal des signaux mentionnés précédemment, caractérisé par le fait que le nombre des emplacements de mémoire est ramené à un huitième et occupe par conséquent un octant de l'espace mémoire nécessaire pour une interpolation complète sur 360°, des valeurs d'interpolation précises étant obtenues en procédant à plusieurs transformations différentes d'adresse et en ajoutant ou soustrayant différentes constantes aux ou des données d'interpolation dans les emplacements de mémoire adressés.

2. Mémoire pour un procédé selon la revendication 1, caractérisée par le fait qu'une zone (Z1) triangulaire d'emplacements de mémoire de l'octant est transformée en une zone (Z2) quadrangulaire d'emplacements de mémoire.

3. Procédé selon la revendication 1, caractérisé par le fait que chaque signal (U1, U2) périodique analogique est transformé par un convertisseur (A/D) analogique/numérique en un mot numérique comportant chaque fois une pluralité de bits auxquels est associé une adresse de la mémoire (Z, Z3).

4. Mémoire selon la revendication 2, caractérisée par le fait que la mémoire (Z) peut être intégrée dans un circuit à intégration à très grande échelle.

5. Procédé selon la revendication 1, caractérisé par le fait que l'on obtient, à partir des données d'interpolation en différents emplacements de mémoire, des messages d'erreur lorsque les signaux analogiques (U1, U2) sont situés en dehors d'une zone prédéterminée.

8

EP 0 408 799 B1

# FIG.1

9

EP 0 408 799 B1

**FIG. 2**

Z2  45°  Z1  Z  I  II  III  IV  Y  X

| Y | Y3 | Y2 | Y1 | Y0 |
|----|----|----|----|----|
| 15 | 1 | 1 | 1 | 1 |
| 14 | 1 | 1 | 1 | 0 |
| 13 | 1 | 1 | 0 | 1 |
| 12 | 1 | 1 | 0 | 0 |
| 11 | 1 | 0 | 1 | 1 |
| 10 | 1 | 0 | 1 | 0 |
| 9 | 1 | 0 | 0 | 1 |
| 8 | 1 | 0 | 0 | 0 |
| 7 | 0 | 1 | 1 | 1 |
| 6 | 0 | 1 | 1 | 0 |
| 5 | 0 | 1 | 0 | 1 |
| 4 | 0 | 1 | 0 | 0 |
| 3 | 0 | 0 | 1 | 1 |
| 2 | 0 | 0 | 1 | 0 |
| 1 | 0 | 0 | 0 | 1 |
| 0 | 0 | 0 | 0 | 0 |
| | Y3 | Y2 | Y1 | Y0 |
| | MSB | | | |

| | 0 | 1 | 2 | 3 | 4 | 5 | 6 | 7 | 8 | 9 | 10 | 11 | 12 | 13 | 14 | 15 |
|------|---|---|---|---|---|---|---|---|---|---|----|----|----|----|----|----|
| MSB X3 | 0 | 0 | 0 | 0 | 0 | 0 | 0 | 0 | 1 | 1 | 1 | 1 | 1 | 1 | 1 | 1 |
| X2 | 0 | 0 | 0 | 0 | 1 | 1 | 1 | 1 | 0 | 0 | 0 | 0 | 1 | 1 | 1 | 1 |
| X1 | 0 | 0 | 1 | 1 | 0 | 0 | 1 | 1 | 0 | 0 | 1 | 1 | 0 | 0 | 1 | 1 |
| X0 | 0 | 1 | 0 | 1 | 0 | 1 | 0 | 1 | 0 | 1 | 0 | 1 | 0 | 1 | 0 | 1 |

# FIG. 3

EP 0 408 799 B1